(19) Europäisches Patentamt
European Patent Office
Office européen des brevets

(11) Publication number: 0 209 391 A2

# (12) EUROPEAN PATENT APPLICATION

(21) Application number: 86305529.9

(22) Date of filing: 17.07.86

(51) Int. Cl.4: H 05 K 1/03, C 08 J 5/04

(30) Priority: 17.07.85 JP 157338/85
09.08.85 JP 176321/85

(43) Date of publication of application: 21.01.87 Bulletin 87/4

(84) Designated Contracting States: DE FR GB

(71) Applicant: SUMITOMO CHEMICAL COMPANY, LIMITED, 15 Kitahama 5-chome Higashi-ku, Osaka-shi Osaka 541 (JP)

(72) Inventor: Sugimoto, Hiroaki, 13-5, Kawanishicho-1-chome, Takatsuki-shi (JP)
Inventor: Hayatsu, Kazuo, 11-8, Kamihozumi-2-chome, Ibaraki-shi (JP)
Inventor: Hieda, Kazuo, 8-3, Hamakoshien-3-chome, Nishinomiya-shi (JP)

(74) Representative: Tubby, David George et al, MARKS & CLERK 57-60 Lincoln's Inn Fields, London WC2A 3LS (GB)

## (54) Resin composition and circuit board moulded from the same.

(57) A resin composition comprising 5-60% by weight of fibre obtained by melt spinning an aromatic polyester which exhibits anisotropy when melted and 40-95% by weight of a thermoplastic resin can provide a circuit board which suffers a lineal dimensional change no more than 1% when immersed in a soldering alloy bath at 260°C for 5 seconds and which is also light in weight, nonhygroscopic and has excellent electrical properties.

EP 0 209 391 A2

M&C FOLIO: 799P52627 WANGDOC: 0610H

# RESIN COMPOSITION AND CIRCUIT BOARD MOULDED FROM THE SAME

The present invention relates to a resin composition comprising a thermoplastic resin reinforced by fibres of an aromatic polyester, and also provides a circuit board moulded from such a resin composition, which board is suitable for printed circuitry.

It is necessary that laminates used in electronic devices and the like (typical examples of such laminates being copper-clad laminates and laminated boards for screen-printed circuits) should possess certain specific properties, such as good electrical properties, heat resistance, chemical resistance and water resistance. Currently, epoxy-glass laminates and phenolic laminates are used for printed circuit boards.

Epoxy-glass laminates can be produced by impregnating a cloth made of glass fibres with an epoxy resin, subjecting it to laminate moulding and then curing the moulded product. Phenolic laminates can be produced by impregnating a paper board with a drying oil-modified phenolic resin and then laminate moulding and curing the product.

The production of these laminates, however, requires much time and labour and also involves problems relating to blanking and other matters. Recently, attention has been directed to the possibility of producing circuit boards by injection moulding or compression moulding compositions prepared by blending glass fibre or aramid fibre with a thermoplastic resin. However, it is very difficult to reduce the density of compositions containing glass fibre below 1.5 $g/cm^3$ and, accordingly, circuit boards produced from such compositions tend to be rather heavy. On the other hand, compositions containing aramid fibres, because of their hygroscopicity, are unsuitable for use in association with electrical circuitry.

We have now discovered a composition which has excellent mouldability in such moulding operations as injection moulding or compression moulding, and which is relatively light in weight and nonhygroscopic. Moreover, it has good electrical properties as well as thermal and mechanical properties. Further, the composition has a good tolerance for soldering and dimensional stability.

According to the present invention, a resin composition comprises from 5 to 60% by weight of fibres obtained by melt spinning an aromatic polyester

exhibiting anisotropy when melted and from 40 to 95% by weight of a thermoplastic resin, wherein a moulded product produced by moulding such a composition exhibits a lineal dimensional change not greater than 1% when immersed in a soldering alloy bath at 260°C for 5 seconds.

The invention further provides a circuit board moulded from the composition of the invention.

The polyester which exhibits anisotropy in its molten state employed in the present invention is a polyester which has the property of allowing the transmission of light within a temperature range in which it is flowable, when a powder sample of the polyester is placed on a heater positioned between two polarizing plates crossed at an angle of 90° and the temperature of the sample is increased. Such polyesters may be formed of aromatic dicarboxylic acids and/or aromatic diols and/or aromatic hydroxycarboxylic acids, as well as derivatives thereof, for example as disclosed in Japanese Patent Applications Kokoku (i.e. as published post-examination) No. 18016/81 and No. 20008/80. The polyesters may be polymers of these alone or may include copolymers of these with alicyclic dicarboxylic acids, alicyclic diols, aliphatic diols and derivatives thereof.

Examples of aromatic dicarboxylic acids include terephthalic acid, isophthalic acid, 4,4'-dicarboxydiphenyl, 2,6-dicarboxynaphthalene, 1,2-bis(4-carboxyphenoxy)ethane, and the nuclear-substituted derivatives thereof with one or more alkyl, aryl, alkoxy or halogen substituents.

Examples of aromatic diols include hydroquinone, resorcinol, 4,4'-dihydroxydiphenyl, 4,4'-dihydroxybenzophenone, 4,4'-dihydroxydiphenylmethane, 4,4'-dihydroxydiphenylethane, 2,2-bis(4-hydroxyphenyl)-propane, 4,4'-dihydroxydiphenyl ether, 4,4'-dihydroxydiphenyl sulphone, 4,4'-dihydroxydiphenyl sulphide, 2,6-dihydroxynaphthalene, 1,5-dihydroxynaphthalene, and the nuclear-substituted derivatives thereof with one or more alkyl, aryl, alkoxy or halogen substituents.

Examples of aromatic hydroxycarboxylic acids include p-hydroxybenzoic acid, m-hydroxybenzoic acid, 2-hydroxynaphthalene-6-carboxylic acid, 1-hydroxynaphthalene-5-carboxylic acid, and the nuclear-substituted derivatives thereof with one or more alkyl, aryl, alkoxy or halogen substituents.

Examples of alicyclic dicarboxylic acids include

trans-1,4-dicarboxycyclohexane, cis-1,4-dicarboxycyclohexane and the substituted derivatives thereof with one or more alkyl, aryl or halogen substituents.

Examples of alicyclic and aliphatic diols include trans-1,4-dihydroxycyclohexane, cis-1,4-dihydroxycyclohexane, ethylene glycol, 1,4-butanediol, and xylylene diol.

Among the combinations of the aforesaid materials, there may be mentioned as examples of preferred aromatic polyesters to be used in this invention:

(1) a copolyester comprising from 40 to 70 mole % of p-hydroxybenzoic acid residues, from 15 to 30 mole % of an above-mentioned aromatic dicarboxylic acid residue, and from 15 to 30 mole % of an aromatic diol residue;

(2) a copolyester formed of terephthalic acid and/or isophthalic acid and chlorohydroquinone, phenylhydroquinone and/or hydroquinone; and

(3) a copolyester comprising from 20 to 80 mole % of p-hydroxybenzoic acid residues and from 20 to 80 mole % of 2-hydroxynaphthalene-6-carboxylic acid residues.

These monomers may be converted to the desired polyesters by polycondensation as they are or after they have been esterified with an aliphatic or aromatic monocarboxylic acid or derivative thereof or with an aliphatic alcohol or phenol or derivative thereof, as the case may be.

The polycondensation may be carried out by known means, for example by bulk polymerization, solution polymerization or suspension polymerization. It is preferably effected at a temperature of from 150 to 360°C under ambient pressure or under sub-atmospheric pressure, for example from 10 to 0.1 Torr (1333-13 Pa). The reaction may or may not be carried out in the presence of a polymerization catalyst (such as an antimony, titanium or germanium compound), a stabilizer (such as a phosphorus compound) and/or a filler (such as titanium dioxide, calcium carbonate or talc). The polymer thus obtained is normally heat-treated, as it is or after polymerization, in an inert gas or under reduced pressure to give a material for spinning. It can also be employed after being granulated through an extruder.

The aromatic polyester may be converted into fibres by means of a melt-spinning apparatus, which may be of any desired type. Suitably, the spinning temperature is

from 280 to 420°C, more preferably from 300 to 400°C. Temperatures below 280°C will result in too large a load on the apparatus or insufficiently uniform melting of the sample; on the other hand, temperatures above 420°C will cause unstable spinning due to decomposition and foaming. The fibres obtained by this melt-spinning are then taken up or drawn down as they are or after oiling.

The take-up or drawdown speed is preferably from 10 to 10,000 metres per minute, more preferably from 100 to 2,000 metres per minute to achieve good productivity and stable spinning. The fibres are preferably from 1 to 10 denier in order to achieve a desirable strength and modulus of elasticity.

The resulting fibre may be used as it is, but it is preferably subjected to one or more further treatments, for example heat treatment, drawing or a combination thereof, in order to impart to the fibre even greater strength and/or a higher degree of elasticity.

The fibre preferably has a strength of at least 15 g/d, more preferably at least 20 g/d, and preferably has a modulus of elasticity of at least 500 g/d, more preferably at least 700 g/d.

The fibre can be of various forms, for example a

continuous filament, chopped strands, short fibres or fibres cut and beaten into a pulp.

The thermoplastic resin which is the base material for the composition of the invention is generally selected so that it can produce a moulded product by injection moulding, generally at from 300 to 420°C. Furthermore, the composition prepared by combining this resin and the fibre obtained by melt-spinning the aromatic polyester should not suffer a lineal dimensional change greater than 1% when a moulded product produced from the composition is immersed in a soldering alloy bath at 260°C for 5 seconds, preferably at 280°C for 10 seconds. There is no particular restriction on the nature of the soldering alloy employed for this test; it is generally an alloy formed from a mixture of two or more metals or metal compounds and which forms a molten state when heated to 200°C or higher. A typical example of such an alloy is one formed by melting and mixing bismuth, tin, lead and cadmium, e.g. in a weight ratio of 4:1:2:1.

The thermoplastic resin is preferably a polysulphide, polysulphone, polyimide or aromatic polyether ketone.

Examples of thermoplastic aromatic polyether ketones

are resins containing recurring units represented by the general formula:

$$-[(O\text{-}Ar)_p\text{-}(CO\text{-}Ar)_q]-$$

(in which Ar represents a divalent aromatic group, and the various groups represented by Ar in the recurring unit may be the same or different, and p and q are the same or different and each represents an integer from 1 to 5). If desired, such a resin may contain other recurring units in an amount not exceeding 50 mole %. Examples of such other recurring units include units of formula $-[O\text{-}Ph\text{-}SO_2\text{-}Ph]-$ and $-[O\text{-}Ph\text{-}O\text{-}Ph\text{-}SO_2\text{-}Ph]-$, in which Ph represents a p-phenylene group.

Preferred examples of such thermoplastic aromatic polyether ketone resins are those having recurring units of formula: -[O-Ph-O-Ph-CO-Ph]-, -[O-Ph-CO-Ph]-, $-[O\text{-}Ph\text{-}C(CH_3)_2\text{-}Ph\text{-}O\text{-}Ph\text{-}CO\text{-}Ph]-$ and $-[O\text{-}Ph\text{-}C(CH_3)_2\text{-}Ph\text{-}O\text{-}Ph\text{-}CO\text{-}Ph\text{-}CO\text{-}Ph]-$ (Ph being as defined above). Preferably, the aromatic polyether ketone resin has an intrinsic viscosity of from 0.5 to 2.7. The use of such a resin makes it possible to obtain a moulded product having good workability and a good balance of various properties.

Of these thermoplastic resins, preferred examples

for use as the base material of the composition of the invention are polyphenylene sulphides, polyether sulphones [such as poly(p-hydroxydiphenylsulphone)], polyetherimides and polyether ether ketones. Commercialized resins of this type which are recommended for use in the composition of the invention include Ryton (trade mark, manufactured by Phillips Co.) resin, Victrex (trade mark) and PEEK (both manufactured by ICI) and ULTEM (trade mark, manufactured by General Electric Co.). In addition to these resins, it is possible to use aromatic polyesters which exhibit anisotropy when melted, for example those described above in relation to the fibres.

The resin composition of the invention comprises from 5 to 60% by weight of fibres obtained by melt-spinning an aromatic polyester exhibiting anisotropy when molten and from 40 to 95% by weight of the thermoplastic resin. If the proportion of fibres in the resin is less than 5% by weight, the effect of the fibres as a reinforcement is not exhibited to a satisfactory degree. If this ratio exceeds 60% by weight, the resulting product has unsatisfactory workability. In order to satisfy the requirements both of workability and of surface smoothness of the moulded product, the preferred ratio is from 30 to 40% by weight of the fibres and from 60 to 70% by weight of the thermoplastic resin.

There is no particular restriction in accordance with the invention on the way in which the fibres and the thermoplastic resin are mixed and such mixing may be accomplished in any conventional manner. What is important is that the fibres should at least maintain their form when mixed with the thermoplastic resin and in the course of moulding. In other words, it is necessary that the fibres should have a "deformation temperature" higher than the temperature at which they are mixed with the thermoplastic resin or the moulding temperature. The "deformation temperature" is here defined as the temperature at which the aromatic polyester fibre sample is fluidized to such an extent that it is able to flow through a nozzle of diameter 1 mm and length 10 mm and achieves an apparent viscosity of 48,000 poises, when the fibre sample is heated at a rate of 4°C per minute under a pressure of 100 $kg/cm^2$, using a flow tester CFT-500 manufactured by Shimazu Seisakusho.

If the deformation temperature of the fibre is lower than the mixing or moulding temperature, the fibre will melt and become fluidized and lose its form, so that it cannot perform its intended role but merely disperses in the thermoplastic resin. For example, if the thermoplastic resin used is an aromatic polyether ketone, the mixing and moulding temperatures are usually

around 300-400°C, so that it is desirable to use a fibre whose deformation temperature is above this range, and preferably above 450°C.

Fibres obtained by melt-spinning an aromatic polyester exhibiting anisotropy when melted are superior to ordinary fibres (for example those of nylon 6, nylon 66, polyethylene terephthalate or polyacrylonitrile) in their strength, modulus of elasticity, heat resistance, thermal stability and other properties. Accordingly, the composition of the invention, as compared with compositions filled with inorganic fibres (such as glass fibres or carbon fibre) has excellent melt-flow characteristics, can produce a moulded product having a smooth surface and causes no damage to the moulding machine in the course of the moulding operation. Moreover, circuit boards obtained by moulding such a composition have excellent dimensional stability (i.e. suffer no more than a 1% change in a lineal dimension e.g. length, when immersed in a soldering alloy bath at 260°C for 5 seconds), are light in weight, are non-hygroscopic and have good electrical and mechanical properties, such as strength.

The resin composition of the invention can, if required, incorporate various conventional additives, for example antioxidants, thermal stabilizers,

ultraviolet absorbers, release agents, colouring matter, crystal nucleators or other conventional additives, as well as such fillers as clay, talc, silica, graphite, calcium carbonate, glass particles, alumina etc, provided that the quantities of these are not such as to adversely affect the properties of the product.

Various moulding methods can be employed to mould the composition of the invention into a circuit board. Examples include compression moulding, injection moulding, extrusion moulding and transfer moulding. Of these, injection moulding is preferred in view of the good shape of the resulting products and the productivity.

Various methods are available for forming a circuit and these are well-known to those skilled in the art. For example, a circuit diagram may be screen-printed on the circuit board using a photosensitive resin, after which the board is chemically plated with copper. Alternatively, the board may be first plated with copper or laminated with a copper film, and then a circuit is printed thereon using a photosensitive resin, after which the photosensitive resin portion is etched away with an alkali, acid, sand blast or other means appropriate to the resin.

Circuit boards obtained by moulding the composition of the invention are light in weight, have good strength and excellent mouldability, non-hygroscopicity and electrical properties. Moreover, such boards have good adhesiveness to metal foils, such as copper foil.

The invention is further illustrated by the following Examples.

In these Examples, the tensile test of the fibres was conducted at testing intervals of 20 mm and a pulling rate of 0.5 mm per minute, using an Instron (trade mark) type universal tester No. 1130.

Measurement of optical anisotropy was made by observation with the naked eye, by placing a sample on a heating stage and heating it at the rate of 25°C per minute under polarized light.

Volume resistivity was measured according to JIS K 6911-5-13 by using an ultra-high insulation resistance tester Model TR-450 of Takeda Riken Co., and applying a voltage of 500 V.

Dielectric properties were determined at 1 MHz by a mutural induction bridge method according to JIS K 6911-5-14.

Moulding shrinkage was expressed by the rate of reduction of the horizontal length of the obtained circuit board to the mould dimension (60 mm).

Thermal deformation temperature was measured according to ASTM-D-48.

The soldering tolerance test of the moulded product was conducted using a soldering alloy made of a 4/1/2/1 (by weight) mixture of Bi/Sn/Pb/Cd.

The tensile test and flexural test of the moulded product were conducted according to ASTM-D-638 and STM-D-790, respectively.

Surface roughness of the moulded product was determined by measuring the average roughness (Ra) along the centre line by a surface roughness tester Surfcom 30C of Tokyo Fine Machinery Co.

Preparation of the fibres used is as shown in the following Preparation.

PREPARATION

7.20 kg (40 mole) of p-acetoxybenzoic acid, 2.49 kg (15 mole) of terephthalic acid, 0.83 kg (5 mole) of

isophthalic acid and 5.45 kg (20.2 mole) of 4,4'-diacetoxydiphenyl were supplied into a polymerization vessel having comb-type stirring blades, and there were heated while stirring under a nitrogen gas atmosphere and polymerized at 330°C for 3 hours. During this period, the acetic acid formed was removed and polymerization was carried out under vigorous stirring. Thereafter, the polymerization mixture was cooled gradually, and, on reaching 200°C, the resulting polymer was taken out of the system. The yield of the polymer was 11.00 kg, which was 98.2% of the theoretical yield. The polymer was then crushed into particles of size 2.5 mm or less by a hammer mill manufactured by Hosokawa Micron Co. The polymer particles were further treated in a rotary kiln under a nitrogen atmosphere at 280°C for 5 hours. Optical anisotropy of the product was seen at temperatures above 350°C.

The polyester thus obtained was melt-spun using a 30 mm diameter screw-type extruder. The nozzle used had 308 holes each having a diameter of 0.07 mm and a length of 0.14 mm.

When spinning was carried out at a cylinder tip temperature of 380°C and a spinneret temperature of 360°C, spinning could be accomplished in a very stable way to give light-yellow transparent fibres. When

treated in nitrogen at 320°C for 3 hours, these fibres had a size of 3.21 deniers and showed a strength of 29.1 g/d, an elongation of 2.9% and a modulus of elasticity of 1,010 g/d. The deformation temperature of the fibre was above 450°C.

EXAMPLE 1

A composition was made from a 30:70 (by weight) mixture of the fibre of the Preparation and a polyether sulphone [Victrex (trade mark) 4100G, manufactured by ICI]. These materials were mixed and extruded using a biaxial mixing extruder manufactured by Ikegai Iron Works to granulate them. In this case, both the fibre of the Preparation and the polyether sulphone were mixed by feeding them from a table feeder. (The temperature of the central part of the extruder was 320°C). The resulting pellets (the fibre of the Preparation having been cut by the shearing action of the screw) were moulded by a 1 ounce injection moulding machine Neomat N47/28 manufactured by Sumitomo Heavy Machinery Co. The cylinder temperature was 355°C and the mould temperature 120°C.

The physical properties of the 3 cm x 6 cm x 1 mm thick plate obtained (a circuit board having five holes of 3 mm in diameter) are shown in Table 1. A disc 3 mm

thick and 100 mm diameter was separately moulded in the same way as described above for determining volume resistivity and dielectric constant.

COMPARATIVE EXAMPLES 1 AND 2

By way of comparison, there were produced, in the same way as in Example 1, a circuit board from a non-filled polyether sulphone and a circuit board from a polyether sulphone mixed with 30% by weight of glass milled fibre (REV-8 manufactured by Nihon Plate Glass Co.) as reinforcing fibre. The results of measurements on these boards are shown in Table 1.

EXAMPLE 2

A circuit board was moulded in the same way as in Example 1 except that a polyether-imide [ULTEM (trade mark) 1000 manufactured by General Electric Co.] was used as the base resin material. Granulation was conducted at 340°C and moulding at 370°C. The results of measurements are shown in Table 2.

COMPARATIVE EXAMPLES 3 AND 4

For comparison, circuit boards were made from non-filled polyether-imide and from polyether-imide

mixed with 30% by weight of glass milled fibre (REV-8 manufactured by Nihon Plate Glass Co.) as reinforcement in the same way as in Example 2. The results of measurements of these are shown in Table 2.

EXAMPLE 3

A circuit board was moulded in the same way as in Example 1 except that polyphenylene sulphide [Ryton (trade mark) V-1 manufactured by Phillips Co.] was used as the base resin and that the fibre to resin ratio was changed to 35 to 65 by weight. Granulation was conducted at 260°C and moulding at 290°C. The results of measurements of these are shown in Table 3.

COMPARATIVE EXAMPLE 5

For comparison, a polyphenylene sulphide circuit board was made in the same way as in Example 3 except for the use of glass milled fibre (REV-8 manufactured by Nihon Plate Glass Co.) as reinforcement. The results of measurements are shown in Table 3.

Table 1: Circuit board from polyether sulfone resin composition

| | Example 1 | Comp. Example 1 | Comp. Example 2 |
|---|---|---|---|
| Fiber | Polyester fiber | Non-filled | Glass milled fiber |
| Density of molded product (g/cc) | 1.38 | 1.37 | 1.60 |
| Mold shrinkage (%) | 0.19 | 0.62 | 0.24 |
| Weight increase after immersion in water at 50°C for 48 hours (%) | 0.45 | 0.84 | 0.46 |
| Thermal deformation temp. (18.6 $kg/cm^2$) (°C) | 218 | 203 | 211 |
| Shrinkage after 5-second immersion in soldering bath at 260°C (%) | 0.2 | 2.3 | 0.4 |
| Volume resistivity x $10^{-15}$ (Ω) | 60 | 80 | 20 |
| Dielectric constant | 3.5 | 3.5 | 4.3 |

Table 2: Circuit board from polyether-imide resin composition

| | Example 2 | Comp. Example 3 | Comp. Example 4 |
| --- | --- | --- | --- |
| Fiber | Polyester fiber | Non-filled | Glass milled fiber |
| Density of molded product (g/cc) | 1.30 | 1.27 | 1.51 |
| Mold shrinkage (%) | 0.17 | 0.60 | 0.22 |
| Weight increase after immersion in water at 50°C for 48 hours (%) | 0.36 | 0.67 | 0.35 |
| Thermal deformation temp. (°C) | 212 | 200 | 208 |
| Shrinkage after 5-second immersion in soldering bath at 260°C (%) | 0.2 | 2.1 | 0.4 |
| Volume resistivity x $10^{-15}$ (Ω) | 110 | 120 | 40 |
| Dielectric constant | 3.3 | 3.3 | 4.1 |

Table 3: Circuit substrate from polyphenylene sulfide resin composition

| | Example 3 | Comp. Example 5 |
|---|---|---|
| Fiber | Polyester fiber | Glass milled fiber |
| Density of molded product (g/cc) | 1.36 | 1.63 |
| Mold shrinkage (%) | 0.21 | 0.32 |
| Weight increase after immersion in water at 50°C for 48 hours (%) | 0.34 | 0.25 |
| Thermal deformation temperature (°C) | 249 | 262 |
| Shrinkage after 5-second immersion in soldering bath at 260°C (%) | 0.4 | 0.6 |
| Volume resistivity x $10^{-15}$ (Ω) | 15 | 8 |
| Dielectric constant | 3.6 | 4.6 |

EXAMPLE 4

A thermoplastic aromatic polyether ketone having a basic skeleton of -[O-Ph-O-Ph-CO-Ph]- and an intrinsic viscosity of 1.4 (measured in 98% concentrated sulfuric acid at a concentration of 0.1 g/dl and at 25°C) and the fibre of the Preparation were granulated in the same way as in Example 1. The temperature of the central part of the extruder was set at 350-360°C. The amount of fibre was adjusted by changing the number of filaments or changing the feed of aromatic polyether ketone.

The pellets obtained were moulded by a 1-ounce injection moulding machine Neomat N 47/28 manufactured by Sumitomo Heavy Machinery Co. The cylinder temperature was 370°C and the mould temperature was 160°C. The results of measurements on the moulded product are shown in Table 4.

COMPARATIVE EXAMPLE 6

A moulded product was obtained by carrying out the injection moulding in the same way as in Example 4 except that the fibre of the Preparation was not used. The results of measurements are shown in Table 4. This moulded product had poor mechanical and thermal properties as compared with the moulded product obtained

by using the composition of this invention.

## COMPARATIVE EXAMPLE 7

We tried to carry out extrusion and granulation works in the same way as in Example 4 except that the weight ratio of the aromatic polyether ketone to the fibre of the Preparation was changed to 30 to 70. The composition was very frail and could not be granulated as desired. We tried to mould the material by an injection moulding machine, but the material could not be moulded.

## COMPARATIVE EXAMPLE 8

Mixing and granulation were carried out in the same way as in Example 4 except that glass fibre roving was used as the reinforcing fibre. The properties of the injection moulded product are shown in Table 4.

This moulded product had a high density and a rough surface as compared with the moulded product from the composition of this invention.

This moulded product was also smaller in elongation and lower in impact energy absorption than the one made of the composition according to this invention.

Table 4: Molded products from aromatic polyether ketone resin compositions

| Example | Composition (wt%) | | | Density of molded product | Tensile properties | | | Flexural modulus of elasticity | Thermal deformation temperature | Average surface roughness of molded product Ra |
|---|---|---|---|---|---|---|---|---|---|---|
| | Aromatic polyether ketone | Fiber | | | Strength | Elongation | Modulus of elasticity | | | |
| | | Polyester | Glass | (g/cc) | (MPa) | (%) | (GPa) | (GPa) | (°C) | (μm) |
| Comp. Example 6 | 100 | 0 | 0 | 1.30 | 89 | 80 | 2.7 | 3.8 | 152 | 0.05 |
| Example 4 | 80 | 20 | 0 | 1.31 | 146 | 9 | 4.8 | 6.2 | 246 | 0.09 |
| | 67 | 33 | 0 | 1.33 | 168 | 6 | 5.9 | 8.7 | 258 | 0.18 |
| | 52 | 48 | 0 | 1.34 | 184 | 4 | 7.2 | 9.4 | 272 | 0.56 |
| Comp. Example 7 | 30 | 70 | 0 | Unmoldable | | | | | | |
| Comp. Example 8 | 80 | 10 | 20 | 1.44 | 150 | 4 | 4.8 | 6.4 | 280 | 0.59 |

CLAIMS:

1. A resin composition comprising from 5 to 60% by weight of a fibre obtained by melt-spinning an aromatic polyester exhibiting anisotropy when melted and from 40 to 95% by weight of a thermopoastic resin, wherein a product moulded from said composition suffers a lineal dimensional change no greater than 1% when immersed in a soldering alloy bath at 260°C for 5 seconds.

2. A resin composition according to Claim 1, wherein the thermoplastic resin is at least one of polyphenylene sulphide, polyether sulphone, polyether imide and aromatic polyether ketone.

3. A resin composition according to Claim 1, wherein the thermoplastic resin is an aromatic polyether ketone.

4. A circuit board produced by moulding a resin composition as claimed in any one of Claims 1 to 3.